# EUROPEAN PATENT APPLICATION

(11) **EP 2 838 118 A1**
(43) Date of publication of application: **18.02.2015**
(21) Application number: 13775304.2
(22) Date of filing: 03.04.2013
(51) Int. Cl.: H01L 29/786, H01L 21/336, H01L 51/05, H01L 51/30, H01L 51/40

(54) **ELECTRONIC DEVICE, METHOD FOR MANUFACTURING SAME, AND IMAGE DISPLAY DEVICE**

(30) Priority: 09.04.2012 JP 2012088374
(71) Applicant: Sony Corporation, Tokyo 108-0075 (JP)
(72) Inventor: KATSUHARA Mao, Minato-ku, Tokyo 108-0075 (JP); FUKUDA Toshio, Minato-ku, Tokyo 108-0075 (JP)
(74) Representative: MFG Patentanwälte Meyer-Wildhagen Meggle-Freund Gerhard PartG mbB
(86) International application number: PCT/JP2013/060162
(87) International publication number: WO 2013/153998

(57) **Abstract**

There is provided an electronic device including an electrode structure, an insulating layer, and an active layer. The active layer is formed from an organic semiconductor material. The insulating layer, which is in contact with the active layer, is formed from a cyclic cycloolefin polymer or a cyclic cycloolefin copolymer.

## Description

### Technical Field

The present disclosure relates to an electronic device, a manufacturing method thereof, and an image display device.

### Background Art

Currently, a field effect transistor (FET) including a thin film transistor (TFT) used in a variety of electronic equipment is configured of, for example, a channel formation region and source/drain electrodes formed in a substrate such as a silicon semiconductor substrate or a silicon semiconductor material layer, a gate insulating layer including SiO₂ formed on a surface of the substrate, and a gate electrode disposed to face the channel formation region with the gate insulating layer. In addition, such an FET is simply referred to as a top-gate type FET. Alternatively, the FET is configured by a gate electrode disposed on a base, a gate insulating layer disposed on the base including the gate electrode and including SiO₂, and a channel formation region and source/drain electrodes formed on the gate insulating layer. In addition, such an FET is simply referred to as a bottom-gate type FET. A very expensive device for manufacturing a semiconductor device is used to manufacture the FET having the structure described above, and it is thus necessary to reduce the manufacturing cost.

Among these, recently, electronic devices having an active layer formed of an organic semiconductor material have been actively developed, and in particular, organic electronic devices (which may be simply referred to hereinafter as organic devices) such as organic transistors are attracting attention. The ultimate goal of these organic devices may be to have a low cost, a light weight, flexibility, and high performance. When compared with inorganic materials of which silicon is a prime example, the organic semiconductor material (1) allows a large-sized organic device to be manufactured at a low cost at a low temperature in a simple process, (2) allows the organic device having the flexibility to be manufactured, and (3) allows performance or a physical property of the organic device to be controlled by modifying molecules constituting the organic semiconductor material to a desired form. The organic semiconductor material thus has such various advantages.

An active layer formed of an organic semiconductor material is frequently formed on an insulating material layer. Further, in this case, usually, the active layer is obtained first by forming the insulating material layer, then coating an organic semiconductor material solution on the insulating material layer, and drying. A spin coating method is often used for the coating of the organic semiconductor material solution.

### Citation List

### Patent Literature

- Patent Literature 1: JP 2007-538381T
- Patent Literature 2: JP 2008-535218T
- Patent Literature 3: JP 2009-177136A

### Non-Patent Literature

Non-Patent Literature 1: T. Ohe et.al., App. Phys. Lett. 93, 053303, 2008

### Summary of Invention

### Technical Problem

However, to improve the properties of an organic transistor, techniques for forming a surface improvement layer having a polyethylene resin as a main component between an insulating material layer and an active layer are known from JP 2007-538381T and JP 2008-535218T, for example. Further, as a method for forming such a layer structure, a technique for forming a bilayer structure of an insulating material layer and an active layer by simultaneously dissolving the material constituting the insulating material layer and the organic semiconductor material in a solvent, and coating the resultant mixture, whereby spontaneous phase separation occurs during drying, is known from JP 2009-177136A and T. Ohe et. al., App. Phys. Lett. 93, 053303, 2008, for example. However, the polyethylene resin disclosed in these documents has a low glass transition temperature T_{g} of about 100°C, which causes the thermal reliability of the electronic device to deteriorate, and mechanical properties (shape stability) are also poor. Further, since the electronic device disclosed in these documents has a bottom contact type structure, which has poor reliability, practical use has been difficult.

Therefore, a first aspect of the present disclosure is to provide a structure capable of substantially improving the properties of an active layer, an electronic device having this structure, and an image display device including this electronic device. Further, a second aspect of the present disclosure is to, in addition to the first aspect, provide a method for manufacturing an electronic device that has a layered structure of an organic insulating material layer and an organic semiconductor material layer, in which the interface between the organic insulating material layer and the organic semiconductor material layer has a high level of smoothness, and these layers have a high film thickness precision, and yet are reliably in separate phases.

### Solution to Problem

An electronic device according to the present disclosure for attaining the first object includes an electrode structure, an insulating layer, and an active layer. The active layer is formed from an organic semiconductor material. The insulating layer, which is in contact with the active layer, is formed from a cyclic cycloolefin polymer or a cyclic cycloolefin copolymer.

A method for manufacturing an electronic device according to a first aspect of the present disclosure for attaining the second object includes at least the steps of (A) forming on a base a control electrode and a first insulating layer covering the control electrode, (B) then forming on the first insulating layer a second insulating layer formed from an organic insulating material, and (C) then forming on the second insulating layer an organic semiconductor material layer by forming an organic material solution layer in which an organic semiconductor material has been dissolved in a solvent, and then drying. The organic insulating material is formed from a cyclic cycloolefin polymer or a cyclic cycloolefin copolymer. When the organic material solution layer is formed on the second insulating layer, the organic insulating material and the organic semiconductor material mix at an interface between the second insulating layer and the organic material solution layer due to a surface of the second insulating layer being dissolved by a solvent included in the organic material solution layer. When the organic material solution layer has dried, the second insulating layer and the organic semiconductor material layer separate.

A method for manufacturing an electronic device according to a second aspect of the present disclosure for attaining the second object includes at least the steps of (A) forming on a base a control electrode and a first insulating layer covering the control electrode, and (B) then obtaining a laminated structure of a second insulating layer formed from an organic insulating material and an organic semiconductor material layer formed from an organic semiconductor material by forming on the first insulating layer an organic material solution layer in which an organic insulating material and an organic semiconductor material have been dissolved, and then drying the organic material solution layer. The organic insulating material is formed from a cyclic cycloolefin polymer or a cyclic cycloolefin copolymer. When the organic material solution layer has dried, the second insulating layer and the organic semiconductor material layer separate.

The image display device according to the present disclosure for achieving the above-described first aspect includes an image display unit and a control unit configured to control display of images on the image display unit,
wherein the control unit includes the electronic device according to the present disclosure.

### Advantageous Effects of Invention

The electronic device according to the present disclosure, the manufacturing method thereof, and the image display device according to the present disclosure are formed by an insulating layer formed from a cyclic cycloolefin polymer or a cyclic cycloolefin copolymer that is in contact with an active layer formed from an organic semiconductor material. The cyclic cycloolefin polymer or cyclic cycloolefin copolymer has a glass transition temperature T_{g} that is higher than that of the polystyrene resin used as a surface improvement layer in the past technology. Therefore, problems are less likely to occur due to the thermal processes in the manufacturing steps of the electronic device, a high level of thermal reliability can be imparted to the electronic device, and mechanical properties (shape stability) are good. Moreover, although an improvement in the properties of the electronic device can be achieved, this is thought to be due to a reduction in the carrier trap density at the interface between the active layer and the insulating layer because of the presence of the cyclic cycloolefin polymer or cyclic cycloolefin copolymer at the interface.

Further, in the method for manufacturing an electronic device according to the first embodiment of the present disclosure, when the organic material solution layer has been formed on the second insulating layer (organic insulating material layer), the organic insulating material and the organic semiconductor material mix at the interface between the second insulating layer and the organic material solution layer due to the surface of the second insulating layer being dissolved by the solvent included in the organic material solution layer, but at regions away from the interface, there is no mixing of the organic insulating material and the organic semiconductor material, so that when the organic material solution layer has dried, the second insulating layer and the organic semiconductor material layer separate. In the method for manufacturing an electronic device according to the second embodiment of the present disclosure, when the organic material solution layer has dried, the second insulating layer and the organic semiconductor material layer separate. Therefore, the interface between the second insulating layer and the organic semiconductor material layer has a high level of smoothness, and these layers have a high film thickness precision and yet are reliably in separate phases, so that there is no contamination of the second insulating layer before the organic semiconductor material layer is formed. Consequently, an electronic device can be manufactured that has little unevenness in its properties and has excellent performance.

### Brief Description of Drawings

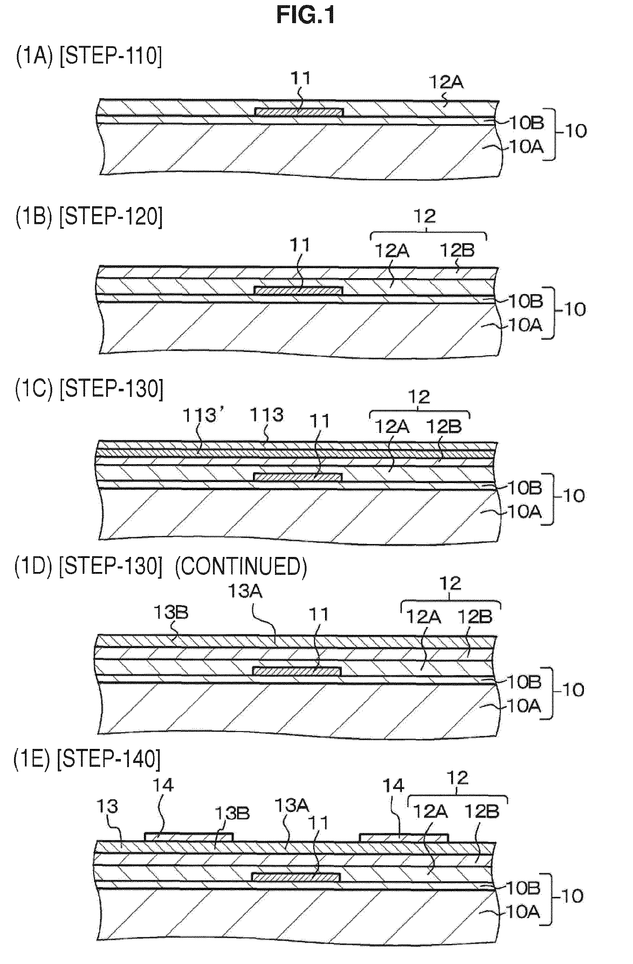

[FIG. 1] FIGS. 1(A) to 1(E) are schematic partial end diagrams of a base and the like for illustrating a method for manufacturing (method for manufacturing an electronic device according to a first embodiment of the present disclosure) the three-terminal type electronic device (bottom-gate/top-contact type semiconductor device) of Working Example 1.

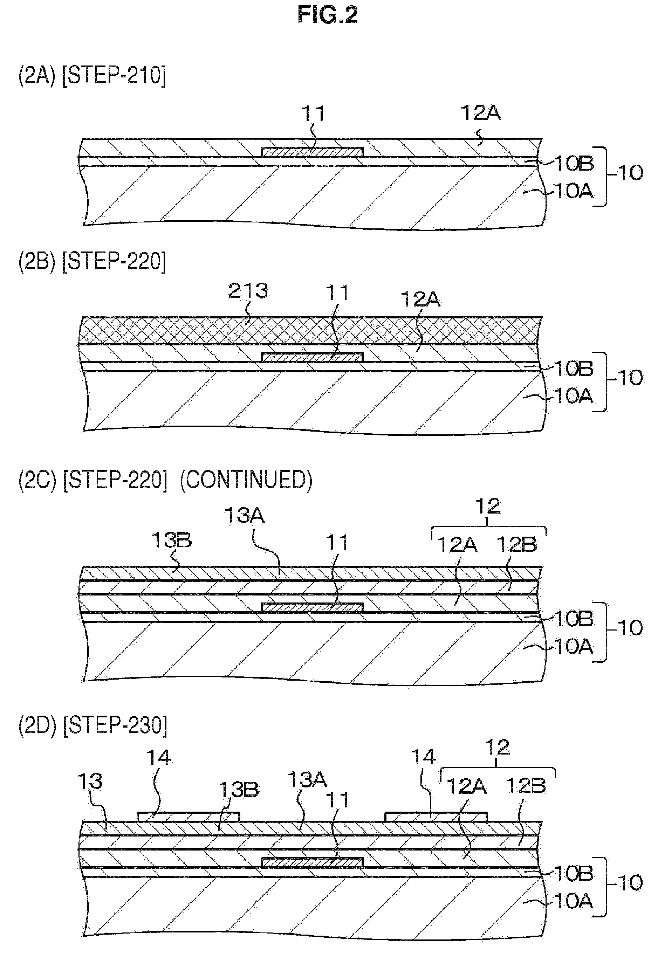

[FIG. 2] FIGS. 2(A) to 2(D) are schematic partial end diagrams of a base and the like for illustrating a method for manufacturing (method for manufacturing an electronic device according to a second embodiment of the present disclosure) the three-terminal type electronic device (bottom-gate/top-contact type semiconductor device) of Working Example 2.

### Description of Embodiments

Hereinafter, preferred embodiments of the present invention will be described in detail with reference to the appended drawings. Note that, in this specification and the drawings, elements that have substantially the same function and structure are denoted with the same reference signs, and repeated explanation is omitted. The description will now be made in the following order.
1. Description relating to the electronic device according to the present disclosure, a manufacturing method thereof, the image display device according to the present disclosure, and general matters
2. Working Example 1 (electronic device and image display device according to the present disclosure, and method for manufacturing the electronic device according to the first embodiment of the present disclosure)
3. Working Example 2 (method for manufacturing the electronic device according to the second embodiment of the present disclosure), and other matters

### Description relating to the electronic device according to the present disclosure, a manufacturing method thereof, the image display device according to the present disclosure, and general matters

The method for manufacturing the electronic device according to the first and second embodiments of the present disclosure may further include a step of forming a first electrode and a second electrode on the organic semiconductor material layer after the organic semiconductor material layer has been formed.

Further, from the perspective of improving the properties of the electronic device, in the electronic device according to the present disclosure, or in the electronic device in the image display device according to the present disclosure, it is preferred that
a first insulating layer and a second insulating layer are laminated to from the insulating layer, and
the second insulating layer is formed from a cyclic cycloolefin polymer or a cyclic cycloolefin copolymer.

Thus, if the electronic device is a configured from a three-terminal type semiconductor device,
the electrode structure is configured from a gate electrode and source/drain electrodes,
the active layer configures a channel formation region and a channel formation region extending portion, and
the insulating layer configures a gate insulating layer. It is noted that the gate electrode corresponds to a control electrode, and the source/drain electrodes corresponds to a first electrode and a second electrode. Further, in this case,
the gate electrode, the gate insulating layer, and the channel formation region may be laminated in that order from the bottom, and
the source/drain electrodes may be formed on the channel formation region extending portion. Namely, this electronic device may be a bottom-gate/top-contact type semiconductor device.

More specifically, if the electronic device is a bottom-gate/top-contact type TFT,
the gate electrode formed on the base or in the base is configured by a control electrode,
the gate insulating layer formed on the gate electrode and the base is configured by an insulating layer,
the channel formation region and the channel formation region extension portion formed on the gate insulating layer are configured by an active layer, and
the pair of source/drain electrodes formed on the channel formation region extension portion is configured by the first electrode and the second electrode. Here, the electrode structure is configured from a control electrode (gate electrode), and the first electrode and second electrode (pair of source/drain electrodes).

In a preferred mode of the method for manufacturing an electronic device according to the first embodiment of the present disclosure, or alternatively, a preferred mode of the below-described electronic device, the rate at which the second insulating layer is dissolved in the solvent when the organic material solution layer is formed on the second insulating layer is preferably more than 0 nm/minute, and not greater than 50 nm/min.

In the electronic device according to the present disclosure, or the electronic device in the image display device according to the present disclosure,
it is preferred that at the interface between the insulating layer and the active layer, the organic insulating material and the organic semiconductor material do not mix and the insulating layer and the active layer are separate. In this case, it is preferred that,
an organic material solution layer in which the organic semiconductor material (material constituting the active layer or the organic semiconductor material layer) is dissolved in a solvent is formed on a second insulating layer (layer configuring the insulating layer or the organic insulating material layer) so that the organic insulating material and the organic semiconductor material mix at the interface between the second insulating layer and the organic material solution layer due to the surface of the second insulating layer being dissolved by the solvent included in the organic material solution layer, and
when the organic material solution layer has dried, the second insulating layer and the organic semiconductor material layer separate. Or alternatively, in this case, it is preferred that,
the second insulating layer (layer constituting the insulating layer or the organic insulating material layer) and the organic semiconductor material layer (layer constituting the active layer) separate by forming the organic material solution layer in which the organic insulating material and the organic semiconductor material are dissolved and then drying the organic material solution layer.

In the electronic device according to the present disclosure and the electronic device in the image display device according to the present disclosure that include the various above-described preferred modes and structures, or, the method for manufacturing an electronic device according to the first and second embodiments of the present disclosure that includes the various above-described preferred modes and structures (hereinafter, these are sometimes collectively referred to simply as "the present disclosure"), when the surface of the second insulating layer is dissolved by the solvent included in the organic material solution layer, the depth to which the second insulating layer is dissolved is preferably, although not limited to, 1×10⁻⁹ m to 1×10⁻⁸ m from the surface of the second insulating layer.

According to the embodiments of the present disclosure, examples of the organic semiconductor material may include polymers and polycyclic condensation products, such as polypyrrole and its derivative substitution; polythiophene and its derivatives; an isothianaphthene, such as polyisothianaphthene; a thienylenevinylene, such as polythienylenevinylene; a poly(p-phenylenevinylene), such as poly(p-phenylenevinylene); polyaniline and its derivatives; polyacetylene; a polydiacetylene; a polyazulene; a polypyrene; a polycarbazole; a polyselenophene; a polyfuran; a poly(p-phenylene); a polyindole; a polypyridazine; polyvinylcarbazole, polyphenylenesulfide, and polyvinylene sulfide. Alternatively, examples may include an oligomer having the same repeating unit as these polymers. Alternatively, further example include an acene, such as naphthacene, pentacene[2,3,6,7-dibenzoanthracene] and its derivatives, anthracene derivatives, oligothiophene derivatives, hexacene, heptacene, dibenzopentacene, tetrabenzopentacene, pyrene, benzopyrene, dibenzopyrene, chrysene, perylene, coronene, terylene, ovalene, quaterrylene, and circumanthracene, and derivatives in which a part of the carbon atoms of the acene are substituted with a functional group such as an N atom, an S atom, and an O atom, or a carbonyl group (dioxaanthanthrene compounds including peri-xanthenoxanthene and its derivatives, triphenodioxazine, triphenodithiazine, hexacene-6,15-quinone, etc.), and derivatives in which a hydrogen atom of these is substituted with another functional group. Alternatively, examples may further include metal phthalocyanines represented by copper phthalocyanine; tetrathiapentalene and its derivaties; tetracarboxylic acid diimides, such as naphthalene 1,4,5,8-tetracarboxylic acid diimide, N,N'-bis(4-trifluoromethylbenzyl)naphthalene 1,4,5,8-tetracarboxylic acid diimide, N,N'-bis(1H,1H-perfluorooctyl), N,N'-bis(1H,1H-perfluorobutyl), and N,N'-dioctylnaphthalene 1,4,5,8-tetracarboxylic acid diimide derivatives; naphthalene tetracarboxylic acid diimides, such as naphthalene 2,3,6,7-tetracarboxylic acid diimide; condensed ring tetracarboxylic acid diimides such as anthracene tetracarboxylic acid diimides, such as anthracene, 2,3,6,7-tetracarboxylic acid diimide; C60, C70, C76, C78, C84, etc. fullerenes and derivatives thereof; carbon nanotubes such as SWNT; and a pigment and its derivatives, such as a merocyanine pigment, a hemicyanine pigment and the like. Alternatively, further examples of organic semiconductor material may include poly-3-hexylthiophene (P3HT) in which a hexyl group is introduced into polythiophene, polyanthracene, triphenylene, polyellurophene, polynaphthalene, polyethylenedioxythiophene, poly(3,4-ethylendioxythiophene)/polystyrenesulfonic acid (PEDOT/PSS), and quinacridone. Alternatively, further examples of organic semiconductor material may include a compound selected from the group consisting of condensed polycyclic aromatic compounds, porphyrin derivatives, phenyl vinylidene-based conjugated oligomers, and thiophene-based conjugated oligomers. Specific examples thereof include condensed polycyclic aromatic compound such as acene-based molecules (pentacene, tetracene etc.), porphyrin molecules, and conjugated oligomers (phenyl vinylidene-based or thiophene-based). Alternatively, further examples of organic semiconductor material may include porphyrin, 4,4'-biphenyldithiole (BPDT), 4,4'-diisocyanobiphenyl, 4,4'-diisocyano-p-terphenyl, 2,5-bis(5'-thioacetyl-2'-thiophenyl)thiophene, 2,5-bis(5'-thioacetyl-2'-thiophenyl)thiophene, 4,4'-diisocyanophenyl, benzidine (biphenyl-4-4'-diamine), TCNQ (tetracyanoquinodimethane), tetrathiafulvalene and its derivatives, charge-transfer complexes represented by a tetrathiafulvalene (TTF)-TCNQ complex, a bisethylenetetrathiafulvalene (BEDTTTF)-perchloric acid complex, a BEDTTTF-iodine complex, and a TCNQ-iodine complex, biphenyl-4,4'-dicarboxylic acid, 1,4-di(4-thiophenylacetylinyl)-2-ethylbenzene, 1,4-di(4-isocyanophenylacetylinyl)-2-ethylbenzene, dendrimer, 1,4-di(4-thiophenylethyl)-2-ethylbenzene, 2,2"-dihydroxy-1,1':4',1"-terphenyl, 4,4'-biphenyldiethanal, 4,4'-biphenyldiol, 4,4'-biphenylisocyanate, 1,4-diacetylbenzene, diethylbiphenyl-4,4'-dicarboxylate, benzo[1,2-c;3,4-c';5,6-c"]tris[1,2]dithiol-1,4,7-trithion, α-sexithiophene, tetrathiotetracene, tetraselenotetracene, tetratelluric tetracene, poly(3-alkylthiophene), poly(3-thiophene-[β]-ethane sulfonic acid), poly(N-alkylpyrrole)poly(3-alkylpyrrole), poly(3,4-dialkylpyrrole), poly(2,2'-thienylpyrrole), and poly(dibenzothiophene sulfide).

Further, specific examples of the cyclic cycloolefin polymer or cyclic cycloolefin copolymer constituting the insulating layer (second insulating layer, organic insulating material layer, organic insulating material) include TOPAS (registered trademark, manufactured by Topas Advanced Polymers GmbH), ARTON (registered trademark, manufactured by JSR Corporation), and ZEONOR (registered trademark, manufactured by Zeon Corporation). Note that the glass transition temperature T_{g} of these materials is shown below.
TOPAS: Approximately 165°C
ARTON: Approximately 165°C
ZEONOR: Approximately 163°C

The solvent included in the organic material solution layer may be appropriately selected from solvents capable of suitably dissolving the organic insulating material or the organic semiconductor material to a desired concentration.

It is noted that in the present disclosure, a more preferred organic semiconductor material is a peri-xanthenoxanthene compound (PXX compound). Further, examples of a more preferred solvent include aromatic organic solvents, such as toluene and xylene, ketone solvents, such as cyclopentanone, and ether solvents, such as PGMEA.

The first insulating layer according to the embodiments of the present disclosure may be a monolayer, or may be multilayer. Examples of the material constituting the first insulating layer not only include an inorganic insulating material, such as a silicon oxide-based material, silicon nitride (SiN_{Y}), and a metal oxide high-dielectric insulating film, such as aluminum oxide (Al₂O₃) and HfO₂, but also a thermosetting resin, such as a phenol resin, a polyimide resin, a novolac resin, a cinnamate resin, an acrylic resin, an epoxy resin, and a poly-para-xylylene resin. These may also be used in combination. Here, examples of the silicon oxide-based material include oxidized silicon (SiOx), BPSG, PSG, BSG, AsSG, PbSG, silicon oxynitride (SiON), SOG (spin-on glass), or a low-permittivity SiO₂-based material (e.g., polyarylether, cycloperfluorocarbon polymer and benzocyclobutene, a cyclic fluororesin, polytetrafluoroethylene, fluorinated aryl ether, fluorinated polyimide, amorphous carbon, and organic SOG). It is noted that examples of the method for forming the first insulating layer include, in addition to the below-described coating methods, below-described physical vapor deposition methods (PVD methods), and various chemical vapor deposition methods (CVD methods), optionally combining any of a lift-off method, a sol-gel method, an electrodeposition method, and a shadow mask method with a patterning technique. When forming the second insulating layer formed of an organic insulating material on the first insulating layer, or alternatively, an organic material solution layer on the first insulating layer, it is preferred that the first insulating layer is constituted from a material in which the surface of the first insulating layer does not dissolve.

A coating method, for example, can be used as the method for forming an organic material solution layer in the method for manufacturing an electronic device according to the first or second embodiment of the present disclosure. Here, examples of the coating method may include various printing methods, such as a screen printing method, an ink jet printing method, an offset printing method, a reverse offset printing method, a gravure printing method, a gravure offset printing method, relief printing, flexo printing, and a micro contact method; a spin coating method; various coating methods, such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit coater method, a slit orifice coater method, a calender coater method, a casting method, a capillary coater method, a bar coater method, and a dipping method; a spray method; a method using a dispenser; and a method that coats a wet mat such as a stamp method. The second insulating layer and the organic semiconductor material layer may optionally be patterned based on a known method, such as a wet-etching method, a dry-etching method, or a laser ablation method. Further, in this case, it is preferred to coat the patterned second insulating layer and the patterned organic semiconductor material layer with a passivation film.

Although it depends on the materials constituting the second insulating layer, in addition to the above-described coating methods, various below-described PVD methods, including a resistance heating evaporation method, a sputtering method, and a vacuum deposition method, and various CVD methods, may also be used as the method for forming the second insulating layer in the method for manufacturing an electronic device according to the first embodiment of the present disclosure.

According to the present disclosure, the base can be configured by a silicon oxide-based material (e.g., SiOₓ, spin-on glass (SOG), silicon nitride (SiN_{Y}); and a metal oxide high-dielectric insulating film, such as aluminum oxide (Al₂O₃) and HfO₂. If the base is configured by these materials, the base may be formed on a support member (or above a support member) appropriately selected from among the materials listed below. Namely, examples of the support member, or alternatively, a base other than the above-described base, include a flexible plastic film, a plastic sheet, or a plastic substrate, such as polymethylmethacrylate (PMMA), polyvinyl alcohol (PVA), polyvinyl phenol (PVP), polyether sulfone (PES), polyimide, polyamide, polyacetal, polycarbonate (PC), polyethylene terephthalate (PET), polyethylene naphthalate (PEN), polyethyl ether ketone, polyolefins and the like. Alternatively, examples may include mica. If a base configured by such as organic polymer, or a flexible polymer material is used, for example, the electronic device can be mounted on or integrated with an image display device or electronic equipment having a curved surface shape. Alternatively, further examples of the base include various glass substrates, various glass substrates in which an insulating film is formed on the surface, a quartz substrate, a quartz substrate in which an insulating film is formed on the surface, a silicon substrate in which an insulating film is formed on the surface, a sapphire substrate, a metal substrate including an alloy of various metals or various metals, such as stainless steel, aluminum, and nickel, a metal foil, and paper. As the support member having an electrical insulating property, a suitable material may be selected from among the above-described materials. Further examples of the support member include a conductive substrate (a substrate including a metal such as gold and aluminum, a substrate including highly-oriented graphite, a stainless steel substrate etc.). In addition, depending on the mode and structure of the electronic device, the electronic device may be disposed on a support member, and this support member may be configured by the above-described materials. A buffer layer for improving adhesive properties and flatness, a barrier film for improving gas barrier properties and the like may also be formed on the above-described base.

Examples of the material constituting the control electrode, first electrode, and second electrode include metals, such as platinum (Pt), gold (Au), palladium (Pd), chromium (Cr), molybdenum (Mo), nickel (Ni), aluminum (Al), silver (Ag), tantalum (Ta), tungsten (W), copper (Cu), titanium (Ti), indium (In), tin (Sn), iron (Fe), cobalt (Co), zinc (Zn), magnesium (Mg), manganese (Mn), ruthenium (Rh), and a rubidium (Rb), or, conductive substances, such as an alloy including these metals elements, conductive particles including these metals, conductive particles including an alloy of these metals, polysilicon containing impurities, and the like. A laminated structure layers including these elements can also be used. Further examples of the material constituting the control electrode, the first electrode, or the second electrode, etc. include an organic material (conductive polymer), such as poly (3,4-ethylenedioxythiophene)/polystyrene sulfonate [PEDOT/PSS], TTF-TCNQ, and polyaniline. The materials which constitute the control electrode, the first electrode, or the second electrode, etc. may be the same material or a different material.

Although the method for forming the control electrode, the first electrode and the second electrode depends on the materials constituting these parts, examples may include various coating methods described above; various PVD methods; pulsed laser deposition (PLD), an arc discharge method; various CVD methods including an MOCVD method; a lift-off method; a shadow mask method; as well as a combination of any plating method, such as an electrolytic plating method, an electroless plating method, or a combination thereof, with optionally a patterning technique. Examples of the PVD method include (a) an electron beam heating method, a resistance heating evaporation method, various vacuum deposition methods, such as flash evaporation, a method of heating a crucible and the like (b) a plasma evaporation method, (c) various sputtering methods, such as a diode sputtering method, a direct-current sputtering method, a direct-current magnetron sputtering method, a high-frequency sputtering method, a magnetron sputtering method, an ion beam sputtering method, a bias sputtering method and the like, and (d) various ion plating methods, such as a DC (direct current) method, a RF method, a multi-cathode method, an activation reaction method, a field evaporation method, a high-frequency ion plating method, a reactive ion plating method and the like. When the control electrode, the first electrode and the second electrode are formed based on an etching method, a dry-etching method or a wet-etching method may be employed. Examples of dry-etching methods include ion milling and reactive ion etching (RIE). Further, the control electrode, the first electrode and the second electrode may also be formed based on a laser ablation method, a mask evaporation method, a laser transfer method and the like.

Examples of devices in which the electronic device according to the embodiments of the present disclosure is mounted may include, but are not limited to, an image display device. Here, examples of an image display device may include a so-called desktop type personal computer, a notebook type personal computer, a mobile type personal computer, a PDA (personal digital assistant), a mobile phone, a game machine, electronic paper such as an electronic book and an electronic newspaper, a message board such as a signboard, a poster, and a blackboard, a copy machine, rewritable paper to substitute for printer paper, a calculator, a display unit in household appliances, a card display unit such as a point card, and various image display devices in electronic advertizing and electronic POP (e.g., an organic electroluminescence display device, a liquid crystal display device, a plasma display device, an electrophoretic display device, a cold cathode field emission display device etc.). Further examples include various lighting apparatuses.

If the electronic device according to the present disclosure is applied or used in a display device or various electronic machines, the used electronic device may be used as a monolithic integrated circuit in which multiple electronic devices have been integrated on a support member, or each electronic device may be individually separated and used as a discrete component. Further, the electronic device may be sealed with a resin.

### Working Example 1

Working Example 1 relates to the electronic device according to the present disclosure, specifically, a three-terminal type electronic device (a bottom-gate/top-contact type semiconductor device), and an image display device. Further, Working Example 1 also relates to the method for manufacturing an electronic device and the method for manufacturing an image display device according to the first embodiment of the present disclosure.

The electronic device of Working Example 1 or the below-described Working Example 2 includes an electrode structure, an insulating layer, and an active layer. The active layer is formed from an organic semiconductor material. The insulating layer, which is in contact with the active layer, is formed from a cyclic cycloolefin polymer or cyclic cycloolefin copolymer.

It is noted that, in the following description, the term "gate electrode" may be used instead of "control electrode", the terms "channel formation region and/or channel formation region extension portion" instead of "active layer" and "organic semiconductor material layer", the term "source/drain electrodes" instead of "first electrode and second electrode", the term "second gate insulating layer" instead of "insulating layer", "second insulating layer", and "organic insulating material layer", and the term "first gate insulating layer" instead of "first insulating layer".

Here, the electronic device of Working Example 1 or the below-described Working Example 2 is configured from a three-terminal type semiconductor device, Further, the electrode structure is configured from a gate electrode 11, and, source/drain electrodes 14. An active layer 13 configures a channel formation region 13A and a channel formation region extension portion 13B. An insulating layer configures a second insulating layer 12B. It is noted that the gate electrode 11 corresponds to a control electrode, and the source/drain electrodes 14 correspond to a first electrode and a second electrode.

Further, in the electronic device of Working Example 1, the gate electrode 11, the gate insulating layer 12, and the channel formation region 13A may be laminated in that order from the bottom (the base side), and the source/drain electrodes 14 may be formed on the channel formation region extending portion 13B to form a bottom-gate/top-contact type semiconductor device.

More specifically, in the electronic device of Working Example 1,
the gate electrode 11 formed on the base 10 is configured by a control electrode,
the gate insulating layer (more specifically, the second gate insulating layer) 12B formed on the gate electrode and the base is configured by an insulating layer,
the channel formation region 13A and the channel formation region extension portion 13B formed on the gate insulating layer 12 are configured by the active layer 13, and
the pair of source/drain electrodes 14 formed on the channel formation region extension portion 13B is configured by the first electrode and the second electrode. It is noted that the gate insulating layer (insulating layer) has a layered structure of a first gate insulating layer (first insulating layer) 12A and a second gate insulating layer (second insulating layer) 12B from the gate electrode side.

In Working Example 1, the organic semiconductor material constituting the active layer 13 (organic semiconductor material layer, channel formation region 13A, and channel formation region extension portion 13B) is, specifically, formed from a peri-xanthenoxanthene (6,12-dioxaanthanthrene) derivative, and more specifically, ethylphenyl-PXX, and toluene is used as the solvent. Further, the cyclic cycloolefin polymer or cyclic cycloolefin copolymer serving as the organic insulating material constituting the insulating layer (organic insulating material layer, second insulating layer, second gate insulating layer) 12B is, specifically, formed from TOPAS, and xylene is used as the solvent. It is noted that the solution in which the organic semiconductor material is dissolved in a solvent is sometimes referred to as "organic semiconductor material solution", and the solution in which the organic insulating material is dissolved in a solvent is sometimes referred to as "organic insulating material solution". The same also applies below.

The method for manufacturing the three-terminal type electronic device (bottom-gate/top-contact type semiconductor device) of Working Example 1 will be described with reference to FIGS. 1(A) to 1(E), which are schematic partial end views of the base and the like.

First, the gate electrode 11, and the first gate insulating layer 12A covering the gate electrode 11, are formed on the base 10, which is formed from a glass substrate 10A on which an insulating film 10B formed from SiO₂ is formed on the surface.

### Step-100

Specifically, based on a photolithography technique, a resist layer (not illustrated), from which the portion where the gate electrode 11 is to be formed has been removed, is formed on the insulating film 10B formed from SiO₂ that is formed on the surface of the glass substrate 10A. Then, a titanium (Ti) layer (not illustrated) as an adhesion layer and a gold (Au) layer as the gate electrode 11 are successively deposited on the whole face by a vacuum deposition method, after which the resist layer is removed. In this way, based on a so-called lift-off method, the gate electrode 11 can be obtained (refer to FIG. 8A). It is noted that the gate electrode 11 can also be formed on the insulating film 10B formed from SiO₂ that is formed on the surface of the glass substrate 10A based on a printing method.

### Step-110

Next, the first gate insulating layer 12A formed from SiO₂ is formed on the base 10 and the gate electrode 11 based on a sputtering method. In this way, the structure illustrated in FIG. 1(A) can be obtained.

### Step-120

Then, a second gate insulating layer 12B formed from an organic insulating material is formed on the first gate insulating layer 12A. Specifically, the second gate insulating layer 12B having a thickness of 20 nm can be formed by depositing the insulating material solution on the first gate insulating layer 12 by a slit coater method, and then drying at 140°C. In this way, the structure illustrated in FIG. 1(B) can be obtained.

### Step-130

Next, the channel formation region 13A and the channel formation region extension portion 13B can be formed by depositing an organic semiconductor material solution 113 on the second gate insulating layer 12B by a slit coater method, and then drying at 140°C. In this way, the structure illustrated in FIG. 1(D) can be obtained. Here, when the organic semiconductor material solution has been deposited on the second gate insulating layer 12B, the organic insulating material and the organic semiconductor material mix at the interface (indicated by reference numeral 113' in FIG. 1(C)) between the second insulating layer 12B and the organic material solution layer due to the surface of the second insulating layer 12B being dissolved by the solvent included in the organic material solution layer. When the organic material solution layer has dried, the second insulating layer 12B and the channel formation region 13A and channel formation region extension portion 13B separate (refer to FIG. 1(D).

### Step-140

Then, source/drain electrodes 14 are formed on the channel formation region extension portion 13B. Specifically, source/drain electrodes 14 configured from a 100 nm-thick gold (Au) layer are formed by a vacuum deposition method (refer to FIG. 1(E)). When depositing the source/drain electrodes 14, the source/drain electrodes 14 can be formed without using a photolithography process by covering a part of the channel formation region 13A and the channel formation region extension portion 13B with a hard mask. It is noted that the source/drain electrodes 14 can also be formed based on a printing method.

### Step-150

For example, in the manufacture of an image display device, following on from this step, an image display device can be manufactured by forming an image display unit (specifically, an image display unit including an organic electroluminescence element or an electrophoretic display element, a semiconductor light emitting element or the like) based on a known method on or above the thus-obtained TFT, which is an electronic device configuring the control unit (pixel drive circuit) of an image display device. Here, the thus-obtained electronic device configuring the control unit (pixel drive circuit) of an image display device and the electrodes (e.g., pixel electrodes) in the image display unit may be, for example, connected by a connection portion such as a contact hole or a wire. In the below-described Working Example 2 as well, an image display device can be obtained by carrying out a similar step after manufacture of the electronic device is completed.

Alternatively, a passivation film (not illustrated) is formed on the whole face. By doing so, a bottom-gate/top-contact type semiconductor device (a FET, specifically, a TFT) can be obtained. Alternatively, a passivation film (not illustrated) may be formed on the whole face after patterning the channel formation region extension portion 13B and the second gate insulating layer 12B. This enables the adhesive properties of the active layer 13 and the second gate insulating layer 12B to be improved.

The electronic device according to Working Example 1 or Working Example 2 is formed by an insulating layer formed from a cyclic cycloolefin polymer or a cyclic cycloolefin copolymer that is in contact with an active layer formed from an organic semiconductor material. Therefore, a high level of thermal reliability can be imparted to the electronic device without problems occurring due to the thermal processes in the manufacturing steps of the electronic device, and moreover mechanical properties (shape stability) are also good. In addition, an improvement in the properties of the electronic device can be achieved.

In some cases, the second gate insulating layer 12B can be formed on the base 10 and the gate electrode 11 without forming the first gate insulating layer 12A.

### Working Example 2

Working Example 2 relates to a method for manufacturing an electronic device according to the second embodiment of the present disclosure. Although a schematic partial end diagram of the electronic device of Working Example 2 is illustrated in FIG. 2(D), the basic configuration and structure of the electronic device of Working Example 2 is the same as the configuration and structure of the electronic device described in Working Example 1.

In Working Example 2, the cyclic cycloolefin polymer or cyclic cycloolefin copolymer serving as the organic insulating material constituting the insulating layer (organic insulating material layer, second insulating layer, second gate insulating layer) 12B is, specifically, formed from TOPAS, the organic semiconductor material constituting the active layer 13 (organic semiconductor material layer, channel formation region 13A, and channel formation region extension portion 13B) is, specifically, formed from ethylphenyl-PXX, and xylene is used as the solvent.

The method for manufacturing the electronic device of Working Example 2 will now be described with reference to FIGS. 2(A) to 2(D), which are schematic partial end views of the base and the like.

### Step-200

First, a control electrode (gate electrode 11) is formed on the base 10 in the same manner as in Step 100 of Working Example 1.

### Step-210

Next, a first insulating layer that covers the base 10 and the control electrode is formed. Specifically, a polyvinylphenol (PVP) solution that includes a crosslinking agent is coated on the base 10 and the gate electrode 11 by a slit coater method, and then heated to 150°C to obtain a first gate insulating layer 12A formed from polyvinylphenol. In this way, the structure illustrated in FIG. 2(A) can be obtained.

### Step-220

Then, an organic material solution layer 213 in which the organic insulating material and the organic semiconductor material are dissolved in a solvent is formed on the first gate insulating layer 12A. Specifically, the second insulating layer (second gate insulating layer) 12B having a thickness of 20 nm and the active layer 13 (organic semiconductor material layer, channel formation region 13A, and channel formation region extension portion 13B) can be obtained by depositing the organic semiconductor material solution layer 213 on the first gate insulating layer 12 by a slit coater method, and then drying at 140°C.

Here, the organic material solution layer 213 is formed on the first gate insulating layer 12A (refer to FIG. 2(B)), and then when the organic material solution layer 213 has dried, the second gate insulating layer 12B and the channel formation region 13A and channel formation region extension portion 13B separate (refer to FIG. 2(C)). Namely, when the organic material solution layer 213 has dried, the second gate insulating layer 12B and the channel formation region 13A and channel formation region extension portion 13B spontaneously and naturally separate from each other. Consequently, at the interface between the second gate insulating layer 12B and the channel formation region 13A and channel formation region extension portion 13B, the organic insulating material and the organic semiconductor material do not mix, so that a state in which the second gate insulating layer 12B and the channel formation region 13A and channel formation region extension portion 13B are separated can be obtained.

### Step-230

By subsequently performing the same step as Step-140 of Working Example 1 (refer to FIG. 2(D)), and then the same step as Step-150, a bottom-gate/top-contact type semiconductor device semiconductor device (a FET, specifically, a TFT) and image display device can be obtained.

In Working Example 2, when the organic material solution layer 213 has dried, the second gate insulating layer 12B and the channel formation region 13A and channel formation region extension portion 13B separate. Consequently, a high level of smoothness can be obtained at the interface between the second gate insulating layer 12B and the channel formation region 13A and channel formation region extension portion 13B. Further, a high film thickness precision and reliable phase separation can be obtained for these layers. In addition, there is no contamination of the second gate insulating layer 12B before the channel formation region 13A and channel formation region extension portion 13B are formed. As a result of the above, an electronic device can be manufactured that has little unevenness in its properties and has excellent performance.

In the above, although the present disclosure was described based on preferred working examples, the present disclosure is not limited to these working examples. The configuration and structure of the electronic device and the image display device described in the working examples, and the formation conditions, manufacturing conditions and the like of the method for manufacturing an electronic device described in the working examples are examples that can be appropriately changed. The electronic device obtained by the present disclosure can be, for example, when applied or used in a display device or various electronic devices, used as a monolithic integrated circuit in which multiple electronic devices have been integrated on a base, a support, or a support member, or each electronic device may be individually separated and used as a discrete component.

It is noted that the present disclosure can also take the following configurations.
[1] <Electronic device>
   An electronic device including an electrode structure, an insulating layer, and an active layer,
   wherein the active layer is formed from an organic semiconductor material, and
   the insulating layer, which is in contact with the active layer, is formed from a cyclic cycloolefin polymer or a cyclic cycloolefin copolymer.
[2] The electronic device according to [1],
   wherein a first insulating layer and a second insulating layer are laminated to form the insulating layer, and
   wherein the second insulating layer is formed from a cyclic cycloolefin polymer or a cyclic cycloolefin copolymer.
[3] The electronic device according to [1],
   wherein the electronic device is configured from a three-terminal type semiconductor device,
   wherein the electrode structure is configured from a gate electrode and source/drain electrodes,
   wherein the active layer configures a channel formation region and a channel formation region extending portion, and
   wherein the insulating layer configures a gate insulating layer.
[4] The electronic device according to [3],
   wherein the gate electrode, the gate insulating layer, and the channel formation region are laminated in that order from the bottom, and
   wherein the source/drain electrodes are formed on the channel formation region extending portion.
[5] <Method for manufacturing an electronic device: First embodiment>
   A method for manufacturing an electronic device, including at least the steps of:
   (A) forming on a base a control electrode and a first insulating layer covering the control electrode;
   (B) then forming on the first insulating layer a second insulating layer formed from an organic insulating material; and
   (C) then forming on the second insulating layer an organic semiconductor material layer by forming an organic material solution layer in which an organic semiconductor material is dissolved in a solvent, and then drying,
   wherein the organic insulating material is formed from a cyclic cycloolefin polymer or a cyclic cycloolefin copolymer,
   wherein when the organic material solution layer is formed on the second insulating layer, the organic insulating material and the organic semiconductor material mix at an interface between the second insulating layer and the organic material solution layer due to a surface of the second insulating layer being dissolved by a solvent included in the organic material solution layer, and
   wherein when the organic material solution layer has dried, the second insulating layer and the organic semiconductor material layer separate.
[6] <Method for manufacturing an electronic device: Second embodiment>
   A method for manufacturing an electronic device, including at least the steps of:
   (A) forming on a base a control electrode and a first insulating layer covering the control electrode; and
   (B) then obtaining a laminated structure of a second insulating layer formed from an organic insulating material and an organic semiconductor material layer formed from an organic semiconductor material by forming on the first insulating layer an organic material solution layer in which an organic insulating material and an organic semiconductor material are dissolved, and then drying the organic material solution layer,
   wherein the organic insulating material is formed from a cyclic cycloolefin polymer or a cyclic cycloolefin copolymer, and
   wherein when the organic material solution layer has dried, the second insulating layer and the organic semiconductor material layer separate.
[7] The method for manufacturing an electronic device according to [5] or [6], further including a step of:
   after forming the organic semiconductor material layer, forming a first electrode and a second electrode on the organic semiconductor material layer.
[8] <Image display device> An image display device including:
   an image display unit; and
   a control unit configured to control display of images on the image display unit,
   wherein the control unit includes the electronic device according to any one of [1] to [4].

### Reference Signs List

- 10: base
- 10A: glass substrate
- 10B: insulating film
- 11: gate electrode
- 12: gate insulating layer
- 12A: first gate insulating layer (first insulating layer)
- 12B: second gate insulating layer (second insulating layer)
- 13: active layer
- 13A: channel formation region (active layer)
- 13B: channel formation region extension portion (active layer)
- 14: source/drain electrodes
- 113: organic semiconductor material solution
- 113': mixed layer of organic insulating material and organic semiconductor material
- 213: organic material solution layer

## Claims

1. An electronic device comprising:
an electrode structure;
an insulating layer; and
an active layer,
wherein the active layer is formed from an organic semiconductor material, and
wherein the insulating layer, which is in contact with the active layer, is formed from a cyclic cycloolefin polymer or a cyclic cycloolefin copolymer.

2. The electronic device according to claim 1,
wherein a first insulating layer and a second insulating layer are laminated to form the insulating layer, and
wherein the second insulating layer is formed from a cyclic cycloolefin polymer or a cyclic cycloolefin copolymer.

3. The electronic device according to claim 1,
wherein the electronic device is configured from a three-terminal type semiconductor device,
wherein the electrode structure is configured from a gate electrode and source/drain electrodes,
wherein the active layer configures a channel formation region and a channel formation region extending portion, and
wherein the insulating layer configures a gate insulating layer.

4. The electronic device according to claim 3,
wherein the gate electrode, the gate insulating layer, and the channel formation region are laminated in that order from the bottom, and
wherein the source/drain electrodes are formed on the channel formation region extending portion.

5. A method for manufacturing an electronic device, the method comprising at least the steps of:
(A) forming on a base a control electrode and a first insulating layer covering the control electrode;
(B) then forming on the first insulating layer a second insulating layer formed from an organic insulating material; and
(C) then forming on the second insulating layer an organic semiconductor material layer by forming an organic material solution layer in which an organic semiconductor material has been dissolved in a solvent, and then drying,
wherein the organic insulating material is formed from a cyclic cycloolefin polymer or a cyclic cycloolefin copolymer,
wherein when the organic material solution layer is formed on the second insulating layer, the organic insulating material and the organic semiconductor material mix at an interface between the second insulating layer and the organic material solution layer due to a surface of the second insulating layer being dissolved by a solvent included in the organic material solution layer, and
wherein when the organic material solution layer has dried, the second insulating layer and the organic semiconductor material layer separate.

6. A method for manufacturing an electronic device, the method comprising at least the steps of:
(A) forming on a base a control electrode and a first insulating layer covering the control electrode; and
(B) then obtaining a laminated structure of a second insulating layer formed from an organic insulating material and an organic semiconductor material layer formed from an organic semiconductor material by forming on the first insulating layer an organic material solution layer in which an organic insulating material and an organic semiconductor material have been dissolved, and then drying the organic material solution layer,
wherein the organic insulating material is formed from a cyclic cycloolefin polymer or a cyclic cycloolefin copolymer, and
wherein when the organic material solution layer has dried, the second insulating layer and the organic semiconductor material layer separate.

7. The method for manufacturing an electronic device according to claim 5 or 6, further comprising:
a step of, after forming the organic semiconductor material layer, forming a first electrode and a second electrode on the organic semiconductor material layer.

8. An image display device comprising:
an image display unit; and
a control unit configured to control display of an image on the image display unit,
wherein the control unit includes the electronic device according to any one of claims 1 to 4.
